# EUROPEAN PATENT APPLICATION

(11) **EP 1 850 369 A1**
(43) Date of publication of application: **31.10.2007**
(21) Application number: 06425283.6
(22) Date of filing: 28.04.2006
(51) Int. Cl.: H01L 21/027, H01L 21/033, H01L 21/308

(54) **Manufacturing process of an organic mask for microelectronic industry**

(71) Applicant: STMicroelectronics S.r.l., 20041 Agrate Brianza (Milano) (IT)
(72) Inventor: Piumi, Daniele, 20100 Milano (IT); Capetti, Gianfranco, 24010 Sorisole (IT); Alba, Simone, 20138 Milano (IT); Demuro, Carlo, 09131 Cagliari (IT); De Simone, Danilo, 20040 Burago di Molgora (IT)
(74) Representative: Cerbaro, Elena

(57) **Abstract**

A process for manufacturing an organic mask for the microelectronics industry, including the steps of: forming an organic layer (3) on a substrate (2); forming an inorganic mask (6a) on the organic layer (3); and etching selectively the organic layer (3) through the inorganic mask (6a). Furthermore, the step of forming the inorganic mask (6a) envisages: forming at least a first auxiliary layer (5) of a first inorganic material on the organic layer (3); forming a mask layer (6) of a second inorganic material different from the first inorganic material on the first auxiliary layer (5); and shaping the mask layer (6) by means of a dual-exposure lithographic process.

## Description

The present invention relates to a manufacturing process of an organic mask for the microelectronics industry.

It is known that, in the field of microelectronics, the reduction of the dimensions of the components is one of the primary requirements, and this pushes in the direction of refining the processing techniques already used. In particular, the development of lithographic techniques is of great importance.

In this connection, techniques have been proposed that deal with different aspects, even though ones that are frequently closely linked to one another.

For example, the so-called "dual-exposure" lithographic techniques enable a reduction in the minimum pitch between adjacent features below the threshold allowed by a single lithographic process. In practice, a body or a layer of semiconductor material or other material (hereinafter referred to generically as "substrate") is subjected to two etching processes with two resist masks obtained using a same photolithographic mask, in which features with a pre-determined pitch are defined (for example, openings of 40-70 nm with a pitch of 200 nm). In a first step, the photolithographic mask is used for exposing and defining a first resist mask. The substrate is etched through the first resist mask, which is then removed. A second resist mask is then made, using the same photolithographic mask, but in a staggered position by half the pitch with respect to the previous step. The substrate is etched again. Consequently, the features defined in the photolithographic mask are transferred twice in the wafer, in different positions. The pitch is thus halved and can be brought below the minimum value allowed by a single photolithographic process.

Another technique, the so-called "multilayer masking" technique, is used when, for optical or structural reasons, conventional photolithographic processes would require making extremely thin resist masks that are insufficient to protect the substrate to be shaped during the entire etching process (the resist is in fact consumed by the etching agents). According to this technique, the substrate to be processed is preliminarily coated with a thick organic layer and a thin inorganic layer, the latter having a thickness of some tens of nanometres. The organic layer and the inorganic layer can be etched with extremely high selectivity with respect to one another. Using a resist mask defined with a conventional photolithographic process, the inorganic layer is shaped to form an inorganic mask. Given the extremely small thickness of the inorganic layer, the time necessary for shaping is very short and hence there is no risk of the resist mask being consumed completely even though it is thin. The extremely high selectivity enables then definition of a mask in the organic layer without eroding the inorganic mask and hence reproducing the same pattern. Finally, the substrate is etched through the organic mask, which can have an arbitrary thickness, since it does not have to submit to constraints of an optical type.

The need to fabricate devices with a density of components that is increasingly high would in many cases call for integration of the two techniques described above, which, however, are far from compatible.

When the dual-exposure photolithographic techniques are combined with multilayer-masking techniques, it is necessary in fact to deposit, define and remove also the organic layer twice. More precisely, the following steps are necessary:
- deposition of a first organic layer and of a first inorganic layer;
- definition of a first resist mask, by means of exposure through a lithographic mask;
- definition of the first inorganic layer through the first resist mask and of the first organic layer through the first inorganic layer, to form a first organic mask;
- etching of the wafer and removal of the first organic mask;
- deposition of a second organic layer and of a second inorganic layer;
- definition of a second resist mask by means of a new exposure through the same lithographic mask, in a staggered position;
- definition of the second inorganic layer through the second resist mask and of the second organic layer through the second inorganic layer, to form a second organic mask; and
- etching of the wafer and removal of the second organic mask.

In the first place, the process is somewhat complex, because it is indispensable to repeat the steps of deposition and definition twice also for the organic layer. The dual-exposure technique cannot in fact be applied directly to a single inorganic layer, because during the second exposure the parts of the organic layer that have remained unprotected following upon the first exposure would be spoiled. The entire organic layer would thus become unserviceable.

Furthermore, the process entails uneliminable and, in some cases, unacceptable asymmetries. In fact, the structures that are made first in the wafer (i.e., using the first organic mask) undergo a step of removal of organic material twice, whereas the structures defined in the wafer with the second etch (through the second organic mask) are concerned just once. Since the reagents that remove the organic material exert a moderate action of erosion also in regard to some materials present in the wafer (in particular, the semiconductors), the final outcome of a non-homogeneous treatment is precisely a lack of uniformity between structures, which in principle should be identical to one another.

The aim of the present invention is to provide a manufacturing process of an organic mask for the microelectronics industry that is free from the drawbacks described.

According to the present invention a manufacturing process of an organic mask for the microelectronics industry is provided, as defined in Claim 1.

For a better understanding of the invention, some embodiments thereof are now described, purely by way of non-limiting example and with reference to the attached drawings, wherein:
- Figures 1-10 are cross sections through a body in successive steps of a process according to a first embodiment of the present invention;
- Figure 11 is a graph that schematically shows relative positions of parts used in the process illustrated in Figures 1-10, in conditions of correct alignment;
- Figure 12 is a graph that schematically shows relative positions of the parts of Figure 11 in the presence of an alignment error;
- Figures 13-22 are cross-sectional views through a body in successive steps of a process according to a second embodiment of the present invention;
- Figure 23 is a graph that schematically shows relative positions of parts used in the process of Figures 13-22, in conditions of correct alignment; and
- Figure 24 is a graph that shows schematically relative positions of the parts of Figure 23 in the presence of an alignment error.

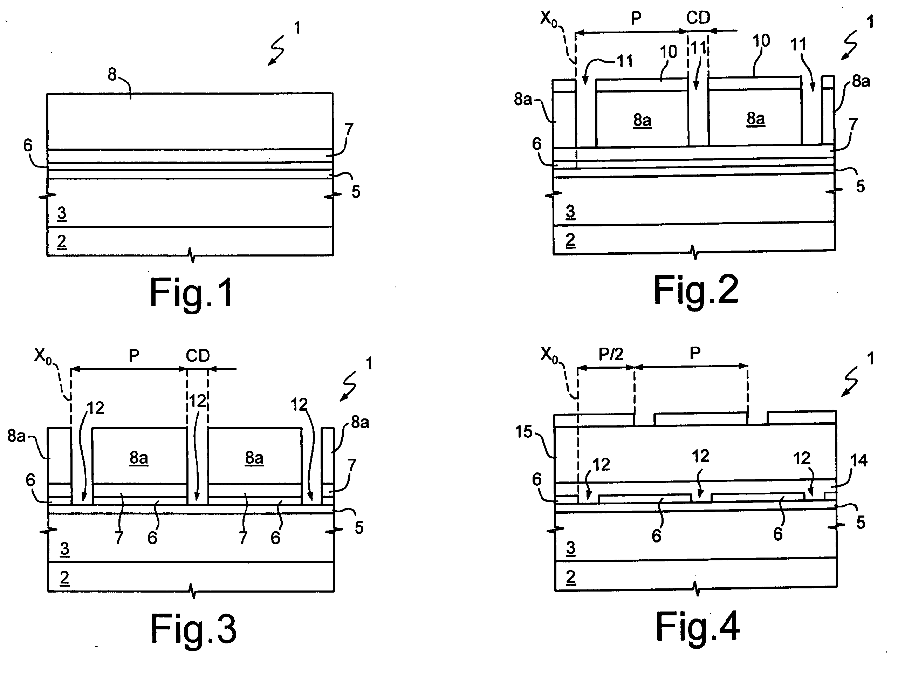

With reference to Figure 1, number 1 designates a semiconductor wafer, which, in the embodiment described herein, comprises a substrate 2 to be shaped, as explained hereinafter, using a mask defined through a dual-exposure lithographic technique. Hereinafter, by the term "substrate" is meant, in a broad sense, any body, layer or film of a semiconductor material or of any material usable in the microelectronics industry. Furthermore, by "dual-exposure lithographic technique" or "dual-exposure lithographic process" is meant a technique or a process that envisages: defining a first resist mask, starting from a first resist layer, which is exposed and developed using a photolithographic mask; making a first etch through the first resist mask; removing the first resist mask; defining a second resist mask, starting from a second resist layer, which is exposed and developed using the same photolithographic mask, but in a staggered position; making a second etch through the second resist mask.

Initially, an organic layer 3, an auxiliary layer 5, and a mask layer 6 are deposited in sequence on the substrate 2. The auxiliary layer 5 is consequently arranged between the organic layer 3 and the mask layer 6.

The organic layer 3 is, for example, made of amorphous carbon and has a thickness of approximately 250 nm. The auxiliary layer 5 and the mask layer 6 have anti-reflecting properties and are made of respective inorganic materials that have high reciprocal selectivity to etching. For example, pairs of suitable materials for the auxiliary layer 5 and the mask layer 6 comprise: silicon oxide SiO₂ and silicon nitride Si₃N₄; silicon oxide SiO₂ and a mixture Si_{X}O_{Y}N_{Z}; a mixture Si_{X}O_{Y}N_{Z} and silicon nitride Si₃N₄; a first mixture Si_{X1}O_{Y1}N_{Z1} and a second mixture Si_{X2}O_{Y2}N_{Z2}, with different stoichiometric amounts. Furthermore, the auxiliary layer 5 and the mask layer 6 are deposited by means of PECVD (Plasma-Enhanced Chemical Vapour Deposition) and have controlled thicknesses of approximately 25-30 nm and approximately 30 nm, respectively.

The mask layer 6 is then coated with a first anti-reflecting layer 7, on which a first resist layer 8 is deposited, having a pre-determined thickness.

As illustrated in Figure 2, the first resist layer 8 is subjected to a first photolithographic process for defining a first resist mask 8a. In this step, a photolithographic mask 10 is used, which has features, in particular openings 11, having a controlled transverse dimension CD, close to the lithographic limit, for example approximately 50 nm. The openings 11 are distributed on the photolithographic mask 10 with a pitch P, for example, of approximately 200 nm. The photolithographic mask 10 is of the dark-field type, with an area of the full portions prevailing over the area of the openings 11. The photolithographic mask 10 is aligned to a first reference position, schematically designated by X₁ in Figure 2.

With reference to Figure 3, the photolithographic mask 10 is removed, and the first anti-reflecting layer 7 and the mask layer 6 are etched through the first resist mask 8a. The etch is stopped at the auxiliary layer 5 and is of short duration, because the mask layer 6 is very thin. In this step, the selectivity to the etches of the auxiliary layer 5 and of the mask layer 6 is moreover exploited.

The pattern defined by the openings 11 of the photolithographic mask 10 is thus transferred a first time to the mask layer 6, whilst the auxiliary layer 5 protects the organic layer 3. In practice, first windows 12 are provided in the mask layer 6, which correspond to the openings 11 of the photolithographic mask 10 and have the same transverse dimension CD.

Then (Figure 4), the first resist mask 8 and the first anti-reflecting layer 7 are removed, and a second anti-reflecting layer 14 and a second resist layer 15 are deposited. The second anti-reflecting layer 14, in particular, fills the first windows 12 of the mask layer 6.

The photolithographic mask 10 is then repositioned on the second resist layer 15 to carry out a second photolithographic process. In this case, the photolithographic mask 10 is aligned to a second reference position X₂ staggered by half the pitch P with respect to the first reference position X₁. Consequently, each opening 11 of the photolithographic mask 10 is located in an intermediate position between two first adjacent windows 12.

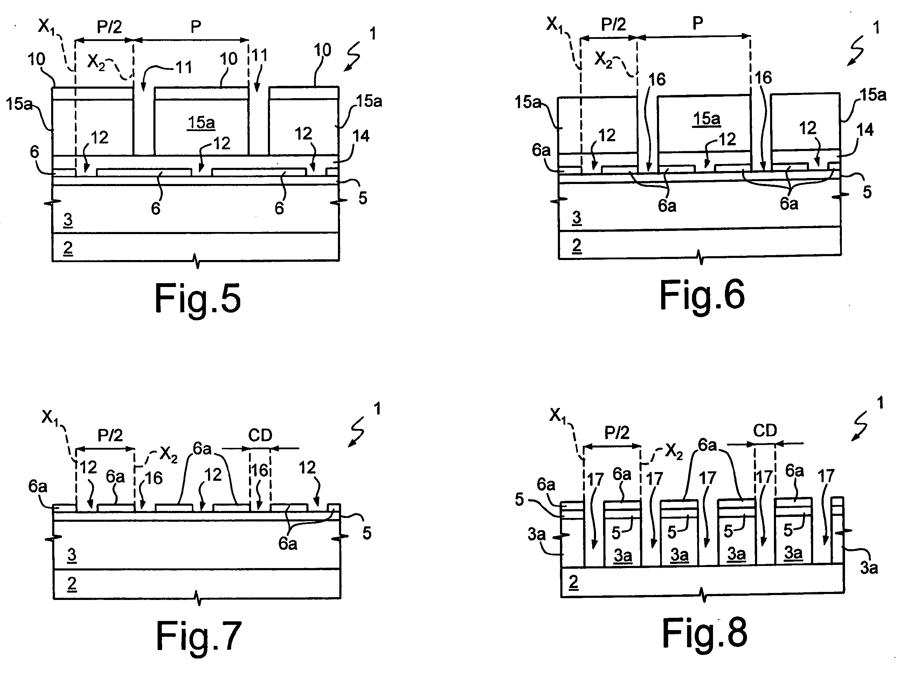

Then (Figure 5), the second resist layer 15 is exposed and developed using the photolithographic mask 10 in the second reference position X₂, to define a second resist mask 15a.

After further removing the photolithographic mask 10 (Figure 6), the second resist mask 15a is used for etching the second anti-reflecting layer 14 and the mask layer 6. As mentioned previously, the etch is stopped at the auxiliary layer 5, which protects the organic layer 3. Second windows 16 are then opened, which are arranged between first adjacent windows 12 and have the same transverse dimension CD. The pattern defined by the photolithographic mask 10 is thus transferred a second time to the mask layer 6, staggered by a distance equal to half the pitch P of the photolithographic mask 10. In practice, residual portions of the mask layer 6 form an inorganic mask 6a, in which the features (first windows 12 and second windows 16) are distributed with a pitch P/2 equal to half the pitch P of the photolithographic mask 10. Next, the auxiliary layer 5 and the organic layer 3 are selectively etched in sequence through the inorganic mask 6a. In this way, an organic mask 3a is obtained, which reproduces the same pattern as the inorganic mask 6a; i.e., it has third windows 17 distributed with the pitch P/2.

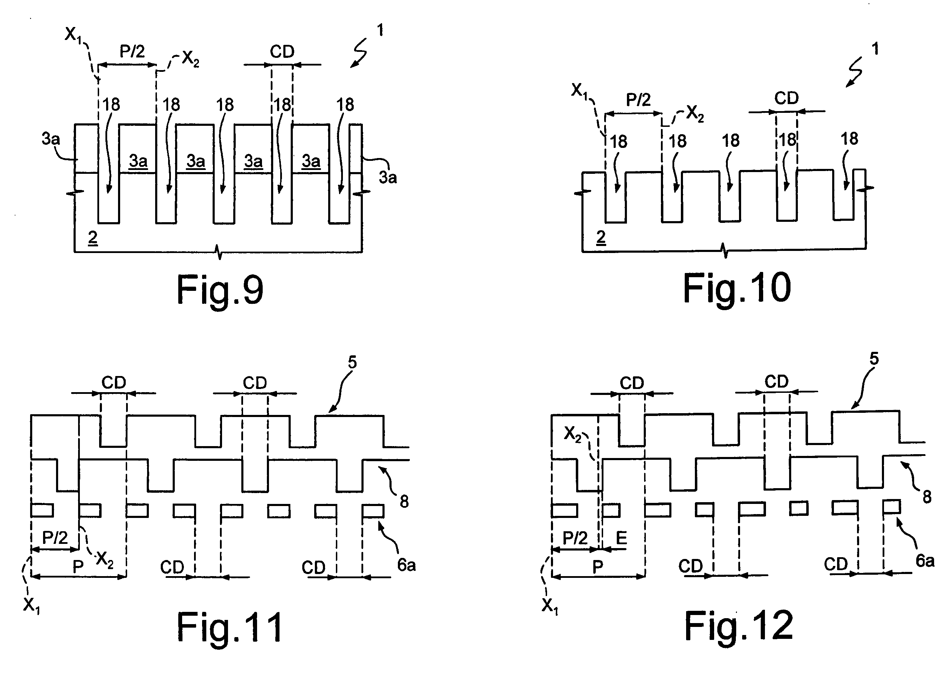

After the inorganic mask 6a and residual portions of the auxiliary layer 5 have been removed, the organic mask 3a is used to open trenches 18 in the substrate 2, as illustrated in Figure 9. Also the trenches 18 have the transverse dimension CD and are distributed in the substrate 2 with the pitch P/2.

Finally (Figure 10), also the organic mask 3a is removed, and the substrate 2 is ready to be subjected to further fabrication steps, according to known processes.

Advantageously, the process described enables integration of a dual-exposure lithographic technique (which enables a reduction in the pitch below the lithographic limits allowed) and a technique of multilayer masking (which enables use of resist layers of small thickness), thus overcoming the difficulties linked to integration.

In particular, the use of two thin inorganic layers enables protection of the underlying organic material during definition of a single inorganic mask with two photolithographic processes. It is thus not necessary to make two separate organic masks, as in conventional processes, to exploit the advantages of the dual-exposure lithographic technique. In addition to being simpler and less costly, the process according to the invention thus enables structures to be obtained that are substantially without any asymmetry because the substrate undergoes removal of the organic mask just once and in any case is treated in a uniform way.

The removal of the inorganic layers does not present difficulties, given the extremely high selectivity to etching of one layer with respect to the other and of both with respect to the organic mask.

The process moreover maintains the same precision as conventional dual-exposure techniques, in which possible errors are substantially linked to an imperfect alignment of the photolithographic mask 10 during the first or second exposure. In this connection see Figures 11 and 12, where the positions of the first resist mask 8a, of the second resist mask 15a, and of the inorganic mask 6a in the case of perfect alignment and in the presence of an error of alignment E, respectively, are schematically represented. The transverse dimension CD is preserved exactly, and the error of alignment is "absorbed" by the portions of the inorganic mask 6a that separate the first windows 12 and the second windows 16.

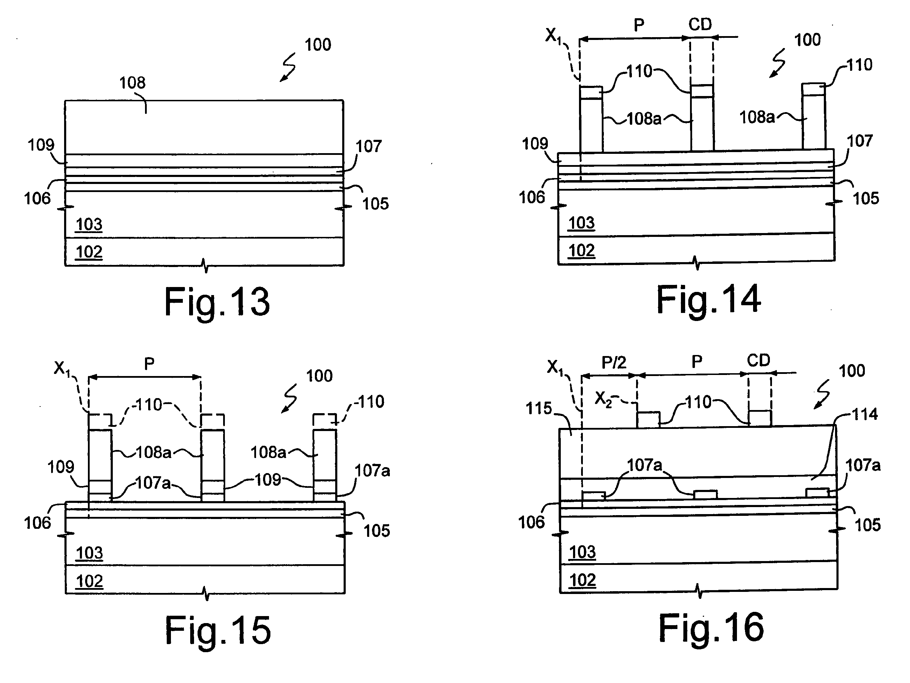

Figures 13-22 illustrate a second embodiment of the invention.

In this case, a semiconductor wafer 100 comprises a substrate 102 (here made of monocrystalline silicon), to be shaped using a mask defined through a dual-exposure lithographic technique. Initially, an organic layer 103, a first auxiliary layer 105, a mask layer 106, and a second auxiliary layer 107 are deposited in sequence on the substrate 102. The first auxiliary layer 105 is consequently arranged between the organic layer 103 and the mask layer 106.

The organic layer 103 is, for example, made of amorphous carbon and has a thickness of approximately 250 nm. The first auxiliary layer 105, the mask layer 106, and the second auxiliary layer 107 are deposited by means of PECVD and have a controlled thickness of between 25 nm and 30 nm (each). Furthermore, the first auxiliary layer 105, the mask layer 106, and the second auxiliary layer 107 present anti-reflecting properties. In the embodiment described here, the first auxiliary layer 105 and the second auxiliary layer 107 are both made of inorganic material. The mask layer 106 is instead made of a different inorganic material, chosen so as to be selectively etchable with respect both to the first auxiliary layer 105 and to the second inorganic layer 107. Also in this case, pairs of suitable materials comprise: silicon oxide SiO₂ and silicon nitride Si₃N₄; silicon oxide SiO₂ and a mixture Si_{X}O_{Y}N_{Z}; a mixture Si_{X}O_{Y}N_{Z} and silicon nitride Si₃N₄; a first mixture Si_{X1}O_{Y1}N_{Z1} and a second mixture Si_{X2}O_{Y2}N_{Z2}, with different stoichiometric amounts (the first auxiliary layer 105 and the second auxiliary layer 107 could in any case be made of different materials, but in any case chosen so as to be selectively etchable with respect to the mask layer 106).

The second auxiliary layer 107 is coated with a first anti-reflecting layer 109, on which a first resist layer 108 is deposited, having a pre-determined thickness.

The first resist layer 108 is subjected to a first photolithographic process for defining a first resist mask 108a, as illustrated in Figure 14. In this step, a photolithographic mask 110 is used, in this case of the bright-field type. In particular, the photolithographic mask 110 has full strips 112, which have a controlled transverse dimension CD and are separated from one another by openings 111. The area of the strips 112 prevails over the area of the openings 111. Furthermore, the transverse dimension CD is close to the lithographic limit; for example, it is approximately 50 nm. The openings 11 are distributed over the photolithographic mask 10 with a pitch P, for example, of approximately 200 nm. The photolithographic mask 10 is aligned to a first reference position, schematically designated by X₁ in Figure 14.

The first resist layer 108 is then exposed through the photolithographic mask 110 and developed to form a first resist mask 108a.

After removing the photolithographic mask 110 (represented with a dashed line in Figure 15), the first resist mask 108a is used for selectively etching the first anti-reflecting layer 109 and the second auxiliary layer 107. The etch is stopped at the mask layer 106 and, in practice, leaves bands 107a of the second auxiliary layer 107 having the transverse dimension CD, underneath the strips 112 of the photolithographic mask 110.

Then (Figure 16), the first resist mask 108a and the first anti-reflecting layer 109 are removed. In their place, a second anti-reflecting layer 114, which incorporates the bands 107a, and a second resist layer 115 are deposited.

The photolithographic mask 110 is then repositioned on the second resist layer 115 to carry out a second photolithographic process. The photolithographic mask 110 is aligned to a second reference position X₂ staggered by half the pitch P with respect to the first reference position X₁. Consequently, each strip 112 of the photolithographic mask 110 is located in an intermediate position between two adjacent bands 107a.

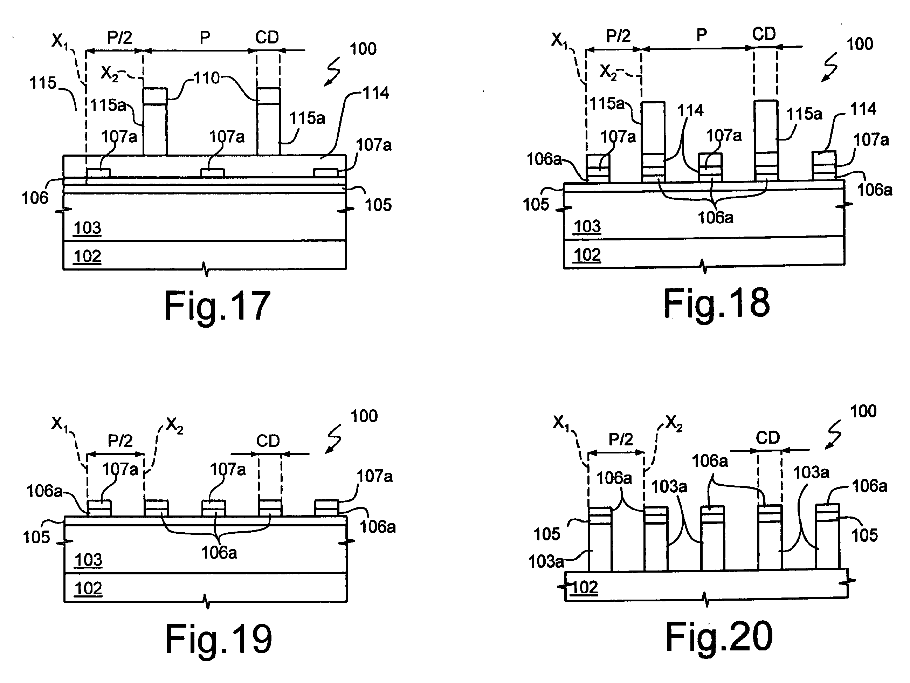

The second resist layer 115 is exposed and developed using the photolithographic mask 110 in the second reference position X₂, to define a second resist mask 115a, as illustrated in Figure 17.

After further removing the photolithographic mask 110 (Figure 18), the second resist mask 115a is used for etching selectively the second anti-reflecting layer 114 and the mask layer 106, to define an inorganic mask 106a. The etch is stopped at the first auxiliary layer 105, which protects the organic layer 103. Given the selectivity of the etch and of the materials forming the layers 105-107, the bands 107a (which are residual portions of the second auxiliary layer 107) are not eroded, even though they remain unprotected. In practice, then, the bands 107a protect underlying portions of the mask layer 106 and co-operate with the second resist mask 115a in shaping the mask layer 106 itself.

The mask 106a consequently comprises residual portions of the mask layer 106 having the transverse dimension CD and distributed with pitch P/2 equal to half the pitch P of the photolithographic mask 110.

The second resist mask 115a and the second anti-reflecting layer 114 are then removed (Figure 19).

As illustrated in Figure 20, the first auxiliary layer 105 and the organic layer 103 are etched through the inorganic mask 106a, to define an organic mask 103a. In greater detail, a selective etch is first performed, which attacks the material of which the first auxiliary layer 105 and the residual bands 107a of the second auxiliary layer 107 are made. In practice, the bands 107a are eliminated, and the first auxiliary layer 105 is shaped according to the conformation of the inorganic mask 106a. Then, the organic layer 103 is etched.

The organic mask 103a reproduces the same pattern as the inorganic mask 106a; i.e., it has bands 117 having the transverse dimension CD distributed with a pitch P/2 equal to half the pitch P of the photolithographic mask 110.

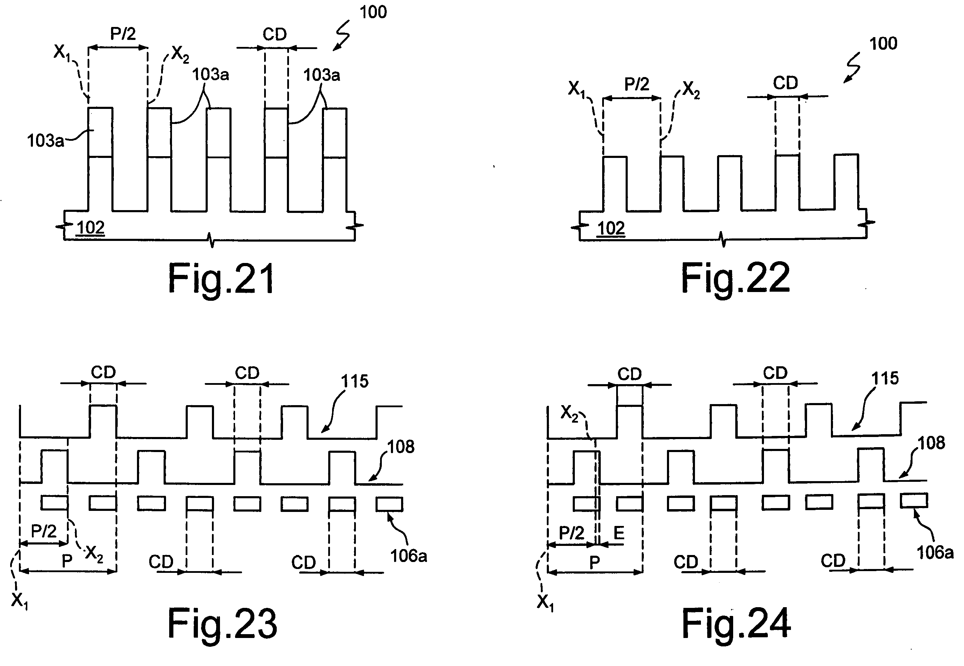

After removal of the inorganic mask 106a and of the residual portions of the first auxiliary layer 105, the organic mask 103a is used to open trenches 18 in the substrate 102, as illustrated in Figure 21. Also the trenches 18 have the transverse dimension CD and are distributed in the substrate 102 with the pitch P/2.

Finally (Figure 22), also the organic mask 103a is removed, and the substrate 102 is ready to be subjected to further fabrication steps, according to known processes.

Also in this case, the precision of the dual-exposure lithographic techniques is preserved. Figures 23 and 24 show schematically the positions of the first resist mask 108a, the second resist mask 115a, and the inorganic mask 106a in the case of perfect alignment and, respectively, in the presence of an error of alignment E. The transverse dimension CD is exactly preserved, and the error of alignment is "absorbed" by the openings of the inorganic mask 106a that separate the residual portions of the mask layer 106.

Finally, it is evident that modifications and variations can be made to the process described herein, without thereby departing from the scope of the present invention, as defined in the annexed claims.

In particular, the auxiliary layer (or layers) and the mask layer can be made of inorganic materials different from the ones referred to, provided that they are suitable to being selectively etched with respect to one another.

Possibly, a step of shrinkage of the transverse dimension of the openings of the resist masks may be envisaged to bring it below the lithographic limit (below 50 nm). For this purpose, it is possible to use known techniques after exposure and development of each resist mask, such as, for example, chemical-shrink techniques. In this case, a known fluid containing reagents is distributed over the surface of the resist mask. By a controlled thermal process, the fluid is made to react with the resist developed and binds thereto, reducing the transverse dimension of the openings. The fluid in excess, which has not reacted, is removed by washing.

Finally, it remains understood that the organic mask obtained with the process according to the invention can be used for carrying out processing steps usable in the microelectronics industry other than a masked etch, such as, for example, an implantation of a dopant species in the substrate.

## Claims

1. A manufacturing process of an organic mask for the microelectronics industry, comprising the steps of:
- forming an organic layer (3; 103) on a substrate (2; 102);
- forming an inorganic mask (6a; 106a) on the organic layer (3; 103); and
- selectively etching the organic layer (3; 103) through the inorganic mask (6a; 106a);
**characterized in that** the step of forming the inorganic mask (6a; 106a) comprises:
- forming at least a first auxiliary layer (5; 105) of a first inorganic material on the organic layer (3; 103);
- forming a mask layer (6; 106) of a second inorganic material different from the first inorganic material on the first auxiliary layer (5; 105); and
- shaping the mask layer (6; 106) by means of a dual-exposure lithographic process.

2. The process according to Claim 1, wherein the step of shaping the mask layer (6; 106) comprises:
- forming a first resist mask (8a; 108a) in a first position (X₁);
- performing out an etch through the first resist mask (8a; 108a);
- removing the first resist mask (8a; 108a);
- forming a second resist mask (15a; 115a) in a second position (X₂), staggered with respect to the first position (X₁); and
- performing an etch through the second resist mask (15a; 115a).

3. The process according to Claim 2, wherein the step of forming the first resist mask (8a; 108a) comprises:
- forming a first resist layer (8; 108) on the mask layer (6; 106);
- placing a photolithographic mask (10; 110) on the first resist layer (8; 108), in the first position (X₁); and
- exposing and developing the first resist layer (8; 108) using the photolithographic mask (10; 110) in the first position (X₁);
and wherein the step of forming the second resist mask (15a; 115a) comprises:
- forming a second resist layer (15; 115) on the mask layer (6; 106);
- placing the photolithographic mask (10; 110) on the second resist layer (15; 115), in the second position (X₂); and
- exposing and developing the second resist layer (15; 115) using the photolithographic mask (10; 110) in the second position (X₂) .

4. The process according to Claim 3, wherein the photolithographic mask (10; 110) comprises features (11; 112) distributed with a pitch (P), and the second position (X₂) is staggered with respect to the first position by half the pitch (P).

5. The process according to any one of Claims 2-4, wherein the step of performing an etch through the first resist mask (8a) comprises selectively etching the mask layer (6).

6. The process according to Claim 5, wherein the step of performing an etch through the first resist mask (8) comprises stopping the etch at the first auxiliary layer (5).

7. The process according to any one of Claims 2-4, comprising the step of forming a second auxiliary layer (107) on the mask layer (106).

8. The process according to Claim 7, wherein the step of performing an etch through the first resist mask (108a) comprises selectively etching the second auxiliary layer (107).

9. The process according to Claim 8, wherein the step of performing an etch through the first resist mask (108) comprises stopping the etch at the mask layer (106).

10. The process according to Claim 8 or Claim 9, wherein the step of performing an etch through the second resist mask (115) comprises selectively etching the mask layer (106).

11. The process according to Claim 10, wherein residual portions (107a) of the second auxiliary layer protect respective underlying portions of the mask layer (106) during the step of performing an etch through the second resist mask (115).

12. The process according to any one of Claims 7-11, wherein the second auxiliary layer (107) is made of the first material forming the first auxiliary layer (105).

13. The process according to any one of the preceding claims, comprising the step of etching the first auxiliary layer (5; 105) through the inorganic mask (6a; 106a).

14. The process according to any one of the preceding claims, wherein the organic layer (3; 103) is made of amorphous carbon.

15. The process according to any one of the preceding claims, wherein the first and second inorganic materials are pairs of materials selected in the group consisting of: silicon oxide SiO₂ and silicon nitride Si₃N₄; silicon oxide SiO₂ and a mixture Si_{X}O_{Y}N_{Z}; a mixture Si_{X}O_{Y}N_{Z} and silicon nitride Si₃N₄; a first mixture Si_{X1}O_{Y1}N_{Z1} and a second mixture Si_{X2}O_{Y2}N_{Z2}, with different stoichiometric amounts.

16. A process for manufacturing a substrate, applicable in the microelectronics industry and comprising the steps of providing a substrate (2; 102), defining an organic mask (3; 103) on the substrate (2; 102), and carrying out a further processing step of the substrate (2; 102) using the organic mask (3; 103);
**characterized in that** the step of defining the organic mask (3; 103) is carried out according to any one of the preceding claims.

17. The process according to Claim 16, wherein carrying out a further processing step of the substrate (2; 102) comprises etching the substrate (2; 102) through the organic mask (3; 103).

18. A body comprising:
- a substrate (2; 102);
- an organic layer (3; 103) on the substrate (2; 102); and
- an inorganic mask (6a; 106a) on the organic layer (3; 103);
**characterized in that** it comprises at least an auxiliary layer (5; 105) of a first inorganic material arranged between the organic layer (3; 103) and the inorganic mask (6a; 106a) and **in that** the inorganic mask (6a; 106a) is of a second inorganic material different from the first inorganic material.
